Europäisches Patentamt

European Patent Office

Office européen des brevets

(11) Publication number: **0 463 325 A2**

# EUROPEAN PATENT APPLICATION

(21) Application number: **91107198.3**

(22) Date of filing: **03.05.91**

(51) Int. Cl.⁵: **H03K 17/56**

(30) Priority: **16.05.90 JP 124191/90**

(43) Date of publication of application:
**02.01.92 Bulletin 92/01**

(84) Designated Contracting States:
**DE FR GB**

(71) Applicant: **Kabushiki Kaisha Toshiba
72, Horikawa-cho Saiwai-ku
Kawasaki-shi(JP)**

(72) Inventor: **Mase, Katsuyoshi, c/o Intellectual
Property Div.
K.K. TOSHIBA, 1-1 Shibaura 1-chome
Minato-ku, Tokyo 105(JP)**

(74) Representative: **Lehn, Werner, Dipl.-Ing. et al
Hoffmann, Eitle & Partner Patentanwälte
Arabellastrasse 4
W-8000 München 81(DE)**

(54) **Device and method for driving semiconductor device having bipolar transistor, insulated gate FET and thyristor combined together.**

(57) This invention relates to a method of driving a semiconductor device having a bipolar transistor, an insulated gate FET and a thyristor combined together. The method is to first drain that part ($I_A1$) of an on-current ($I_A1$, $I_A2$) flowing in the semiconductor device which flows in a bipolar fashion into a base electrode (30) so as to interrupt the thyristor operation, particularly, in the turn-off operation. After this, a channel (22) is extinguished to interrupt a current ($I_A2$) flowing in an FET fashion (unipolar fashion) so as to interrupt the FET operation. The above two steps are sequentially effected to turn off the semiconductor device.

F I G.   2

This invention relates to a device and a method for driving a semiconductor device having a bipolar transistor, an insulated gate FET and a thyristor combined together.

Conventionally, an insulated gate bipolar transistor (which is hereinafter referred to as an IGBT) is known as a semiconductor device having a bipolar transistor, an insulated gate FET and a thyristor combined together, for example. The IGBT is incorporated into an electric power converting inverter device, for example. The switching operation of the IGBT is effected by turning on or off the MOS transistor which is incorporated into the IGBT.

However, when a high withstanding voltage type product is formed by use of the IGBT, the saturation voltage between the collector and emitter of the IGBT becomes high, thereby increasing the loss in the on-state. When the efficiency of injecting carriers into the p-type layer is enhanced in order to lower the saturation voltage between the collector and emitter, a parasitic thyristor incorporated in the IGBT is turned on (latched up) and cannot be turned off.

In order to solve the above problem, a power semiconductor device having a base electrode additionally mounted on the p-type base is proposed. This type of device is sometimes called a MOS assistance gate thyristor (which is hereinafter referred to as an MAGT).

The MAGT has a main feature that a base electrode is formed on the p-type base layer, and the MAGT may effect the turn-off function like a GTO thyristor by use of the base electrode.

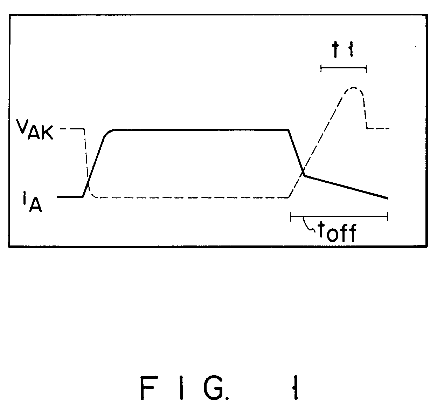

However, since the turn-off operation is effected by transiently reducing the anode current $I_A$ while draining the base current from the p-type base layer in the turn-off method of the normal GTO thyristor, fall of the anode current $I_A$ will be made dull as shown in the turn-off waveform diagram of Fig. 1 ($t_{off}$ in Fig. 1 indicates a turn-off period). Further, a period t1 in which a voltage $V_{AK}$ between the anode and cathode becomes excessively high will occur in the falling period.

As described above, when a device having less power loss in the on-state than the IGBT, that is, the MAGT is turned off in the same manner as the GTO thyristor under the high voltage operating condition, fall of the anode current $I_A$ becomes dull and the turn-off time becomes long. Further, a period in which a voltage $V_{AK}$ between the anode and cathode becomes excessively high exists, the excessively high voltage is actually set to a high level and the power loss becomes large.

This invention has been made in view of the above problems and an object of this invention is to provide a device and a method for driving a semiconductor device which has a bipolar transistor, an insulated gate FET and a thyristor combined together, for example, a semiconductor device such as an MAGT in which the anode current $I_A$ can be instantaneously interrupted when the semiconductor device is turned off so that a period in which a voltage $V_{AK}$ between the anode and cathode becomes excessively high can be reduced and the effective value of the excessively high voltage can be set to a lower level.

In order to attain the above object, a method of driving a semiconductor device according to this invention is constructed as follows:

A method of driving a semiconductor device which includes a thyristor having a first semiconductor layer of a first conductivity type, a second semiconductor layer of a second conductivity type, a third semiconductor layer of the first conductivity type and a fourth semiconductor layer of the second conductivity type, a base electrode connected to the second semiconductor layer, and an insulated gate FET having one of the source and drain connected to the third semiconductor layer, comprising:

(a) a step of turning on the semiconductor device;

(b) a first step of turning off the semiconductor device by interrupting the thyristor operation of the semiconductor device; and

(c) a second step of turning off the semiconductor device by interrupting the FET operation of the semiconductor device.

In the above method of driving the semiconductor device, the thyristor operation for causing current which is part of an on-current flowing in the semiconductor device to flow in a bipolar fashion is first interrupted. Then, the FET operation for causing current to flow in an FET fashion (unipolar fashion) is interrupted. As a result, the semiconductor device is turned off.

The above turn-off operation is effected according to the ON and OFF operations of the FET so that a highspeed switching operation can be attained, a period in which a voltage $V_{AK}$ between the anode and cathode becomes excessively high can be reduced and the effective value of the excessively high voltage can be set to a lower level.

This invention can be more fully understood from the following detailed description when taken in conjunction with the accompanying drawings, in which:

Fig. 1 is a conventional turn-off waveform diagram;

Fig. 2 is a schematic cross sectional view of an MAGT;

Fig. 3 is a timing chart of a driving method according to a first embodiment of this invention;

Fig. 4 is a schematic cross sectional view of an MAGT;

Fig. 5 is a timing chart of a driving method according to a second embodiment of this invention;

Fig. 6 is a diagram of a first driving device for effecting the driving method according to this invention;

Fig. 7 is a timing chart of the first driving device shown in Fig. 6;

Fig. 8 is a circuit diagram of a signal generator;

Fig. 9 is a diagram of a second driving device for effecting the driving method according to this invention;

Fig. 10 is a timing chart of the second driving device shown in Fig. 9;

Fig. 11 is a diagram of a third driving device for effecting the driving method according to this invention;

Fig. 12 is a timing chart of the third driving device shown in Fig. 11;

Fig. 13 is a diagram of a fourth driving device for effecting the driving method according to this invention; and

Fig. 14 is a timing chart of the fourth driving device shown in Fig. 13.

There will now be described an embodiment of this invention with reference to the accompanying drawings.

[First Embodiment]

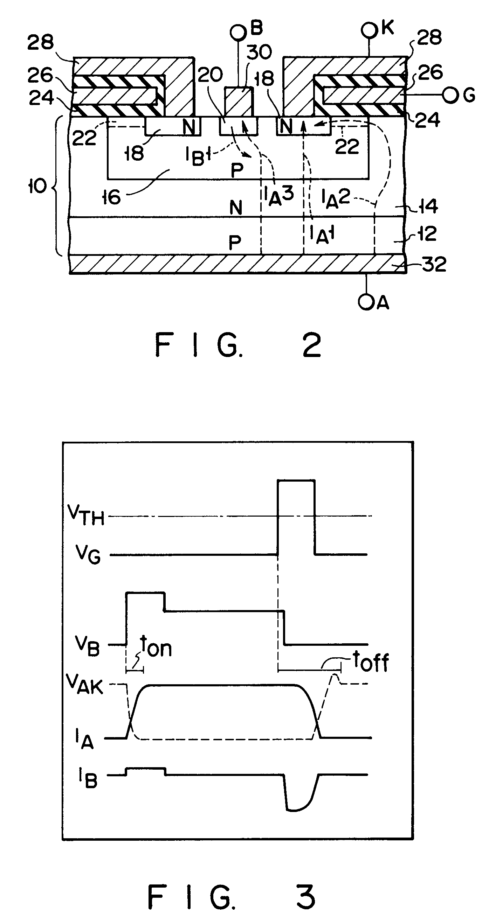

Fig. 2 is a schematic cross sectional view of an MAGT.

As shown in Fig. 2, a semiconductor substrate 10 has a pnpn thyristor structure which includes a $p^+$-type first emitter 12 of high impurity concentration exposed to the rear surface of the semiconductor substrate, an n-type first base layer 14 formed in contact with the $p^+$-type first emitter 12 and partly exposed to the upper surface of the substrate 10, a p-type second base layer 16 formed by selectively diffusing impurity into the n-type first base layer 14 from the upper surface of the substrate 10, and an $n^+$-type second emitter 18 formed by selectively diffusing impurity into the p-type second base layer 16 from the upper surface of the substrate 10. Further, a $p^+$-type base electrode lead-out region 20 of high impurity concentration is formed in the p-type second base layer 16 by selectively diffusing impurity from the upper surface of the substrate 10. A channel region 22 is formed in the surface area of that portion of the p-type second base layer 16 which lies between the n-type second emitter layer 18 and the n-type first base layer 14 when the device is operative. A gate electrode 26 is formed over the channel region 22 with a gate insulation film 24 disposed there between. A cathode electrode 28 is formed in direct contact with and on the n-type second emitter layer 18. A base electrode 30 is formed in direct contact with and on the $p^+$-type base electrode lead-out region 20. An anode electrode 32 is formed in direct contact with and on the p-type first emitter layer 12.

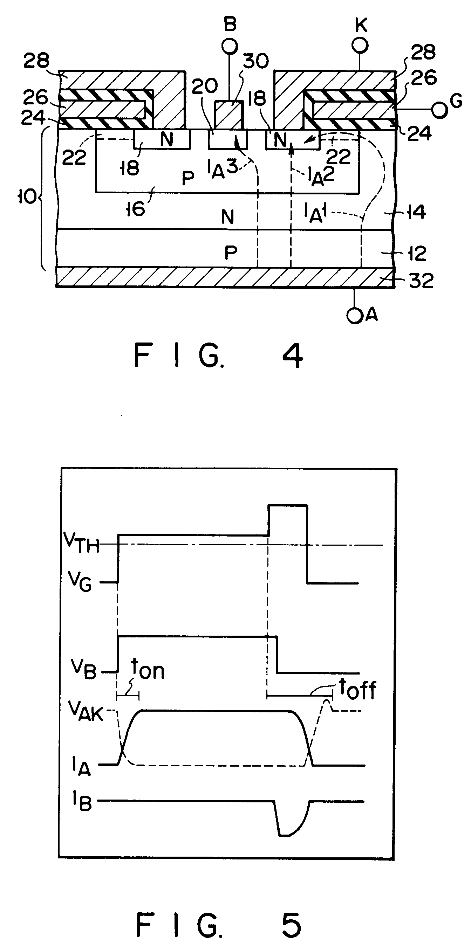

Next, an example of the operation including the turn-off process of the MAGT of the above construction is explained as a first embodiment of this invention with reference to Figs. 2 and 3. Fig. 3 is a timing chart thereof.

First, when the MAGT is turned on ($t_{on}$ in Fig. 3 indicates a turn-on period), a preset potential is applied to the base electrode 30 to inject a base current $I_B$ into the p-type second base layer 16 as indicated by $I_B1$ shown in Fig. 2. As a result, the MAGT is turned on and an on-current $I_A$ flows out along a path of $I_A1$ and the MAGT starts the thyristor operation. A preset potential may be applied to the base electrode 30 as shown in Fig. 3 while the MAGT is operated as a thyristor, for example.

Next, when the MAGT is turned off ($t_{off}$ in Fig. 3 indicates a turn-off period), a preset potential is applied to the gate electrode 26 so as to set a voltage of the gate electrode higher than the threshold voltage $V_{TH}$ of the MOS transistor, causing a voltage between the gate and cathode to form a channel. Therefore, the on-current $I_A$ also flows along a path of $I_A2$ shown in Fig. 2. As a result, the MAGT starts the IGBT operation (FET operation). Next, the potential of the base electrode 30 is lowered to apply a reverse bias voltage between the base and cathode so that part of the on-current $I_A$ which flows along the path of $I_A1$ may be drained into the base electrode 30 along the path of $I_A3$. As a result, the thyristor operation is interrupted.

After this, the potential of the gate electrode 26 is lowered to a level lower than the threshold voltage $V_{TH}$ of the MOS transistor so as to extinguish the channel. Therefore, the on-current $I_A$ flowing along the path of $I_A2$ is interrupted. As a result, the IGBT operation is also interrupted.

Thus, the MAGT is turned off.

[Second Embodiment]

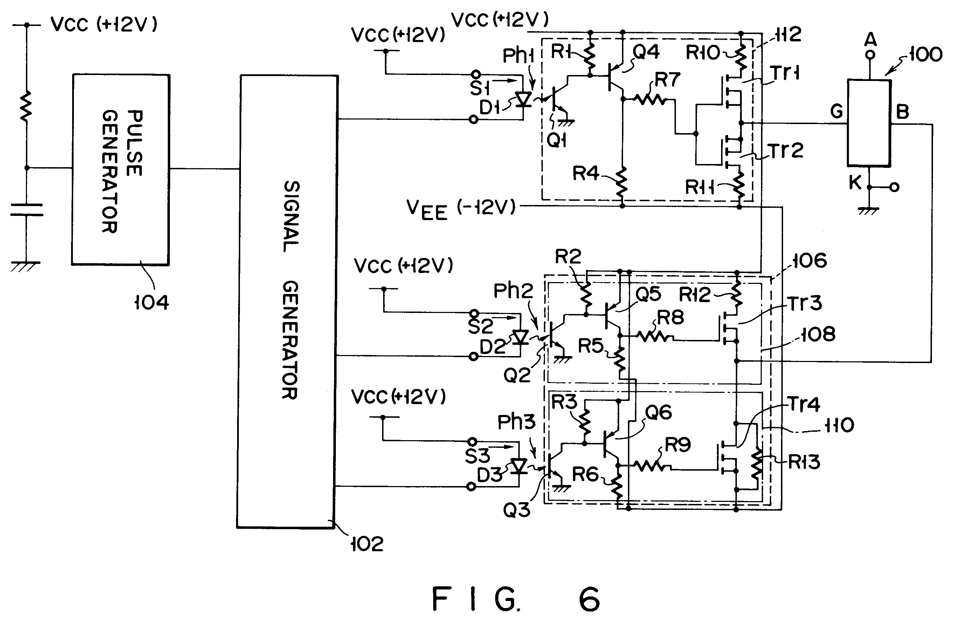

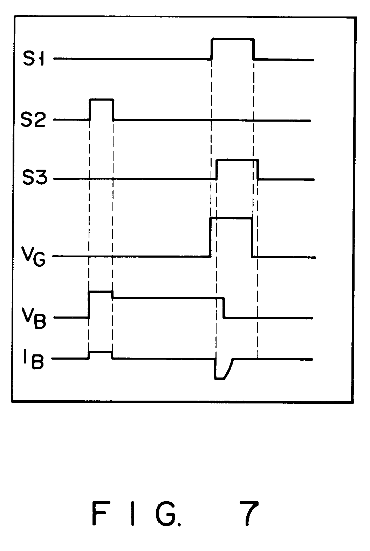

Next, the second embodiment of this invention is explained with reference to Figs. 4 and 5.

Fig. 4 is a schematic cross sectional view of a MAGT which is similar to that of Fig. 2. In Fig. 4, portions which are the same as those of Fig. 2 are denoted by the same reference numerals and the explanation therefor is omitted. Fig. 5 is a timing chart of an example of the operation including the turn-off process.

First, when the MAGT is turned on ($t_{on}$ in Fig. 5

indicates a turn-on period), a preset potential is applied to the gate electrode 26 so as to set a voltage of the gate electrode higher than the threshold voltage $V_{TH}$ of the MOS transistor, causing a voltage between the gate and cathode to form a channel. Therefore, the MAGT is turned on and the on-current $I_A$ flows along the path of $I_A1$ shown in Fig. 5. As a result, the MAGT starts the IGBT operation. At this time, if a voltage higher than the forward voltage of the pn junction is set to occur between the base and cathode, the on-current $I_A$ also flows out along the path of $I_A2$ shown in Fig. 5 and the MAGT starts the thyristor operation. While the MAGT is operated as the thyristor, a preset potential may be applied to the gate electrode 26 as shown in Fig. 5, for example.

Next, when the MAGT is turned off ($t_{off}$ in Fig. 5 indicates a turn-off period), the potential of the gate electrode 26 is further enhanced so as to form a larger channel. Therefore, distribution of the on-current $I_A$ is changed and a larger portion of the on-current $I_A$ flows along the path of $I_A1$ shown in Fig. 4. Next, the potential of the base electrode 30 is lowered to apply a reverse bias voltage between the base and cathode so that part of the on-current $I_A$ which flows along the path of $I_A2$ may be drained into the base electrode 30 along the path of $I_A3$. As a result, the thyristor operation is interrupted.

After this, the potential of the gate electrode 26 is lowered to a level lower than the threshold voltage $V_{TH}$ of the MOS transistor so as to extinguish the channel. Therefore, the on-current $I_A$ flowing along the path of $I_A1$ is interrupted. As a result, the IGBT operation is also interrupted.

Thus, the MAGT is turned off.

In the turn-off methods explained in the first and second embodiments, that part of the on-current $I_A$ which causes the thyristor operation is first drained into the base electrode 30 so as to interrupt the thyristor operation. After this, the on-current which causes the IGBT operation is interrupted by extinguishing the channel so as to interrupt the IGBT operation. Thus, the on-current $I_A$ is completely extinguished by effecting the above two steps to turn off the MAGT.

That is, the turn-off operation of the MAGT according to this invention is not effected by draining and transiently extinguishing all of the on-current $I_A$ as in the GTO thyristor, but effected by finally extinguishing the channel to interrupt the on-current $I_A$ so as to completely extinguish the on-current $I_A$. Therefore, the on-current $I_A$ can be instantaneously interrupted, the turn-off time can be reduced, the excessively high voltage can be set to a lower level, and the loss can be set to a minimum value.

[Third Embodiment]

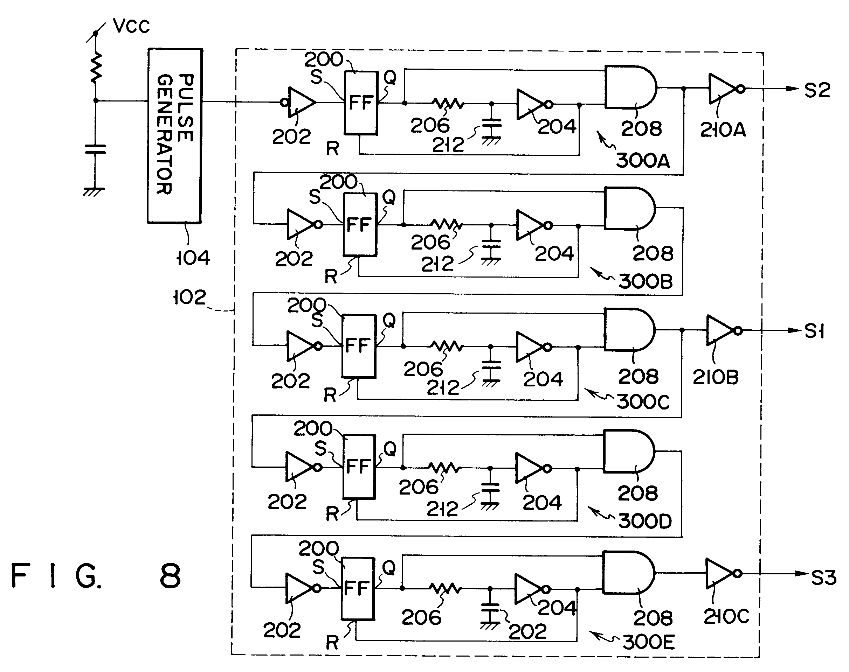

Fig. 6 is a diagram showing a first driving device for effecting the driving method according to this invention. Fig. 7 is a timing chart thereof. The driving device explained in this embodiment is designed particularly for the driving method explained in the first embodiment.

As shown in Figs. 6 and 7, when a MAGT 100 is turned on, a control current signal S2 generated from a signal generator 102 is input to a light emitting element D2 of a photocoupler Ph2. Then, a photo detector Q2 of a turn-on potential supplying section 108 of a base potential supplying section 106 is rendered conductive by the photocoupling effect. When the light receiving element Q2 is rendered conductive, a pnp transistor Q5 whose base is connected to the collector of the transistor Q2 is turned on, and an n-channel MOS transistor Tr3 whose gate is connected to the collector of the transistor Q5 is turned on. As a result, a base current $I_B$ flows into the base of the MAGT 100 and the MAGT 100 is turned on as explained in the first embodiment.

Further, when the MAGT 100 is turned off, a control current signal S1 generated from the signal generator 102 is input to a light emitting element D1 of a photocoupler Ph1, and a photo detector Q1 of a gate potential supplying section 112 is rendered conductive by the photocoupling effect. When the photo detector Q1 is rendered conductive, a pnp transistor Q4 whose base is connected to the collector of the transistor Q1 is turned on, and then an n-channel MOS transistor Tr1 whose gate is connected to the collector of the transistor Q4 is turned on. As a result, a potential nearly equal to a VCC level is applied to a gate G of the MAGT 100. Then, in the MAGT 100, a channel is formed as explained in the first embodiment and the MAGT 100 starts the IGBT operation.

Next a control current signal S3 generated from the signal generator 102 is input to a light emitting element D3 of a photocoupler Ph3, and a photo detector Q3 of a turn-off potential supplying section 110 of the base potential supplying section 106 is rendered conductive by the photocoupling effect. When the light receiving element Q3 is rendered conductive, a pnp transistor Q6 whose base is connected to the collector of the transistor Q3 is turned on, and then an n-channel MOS transistor Tr4 whose gate is connected to the collector of the transistor Q6 is turned on. As a result, the on-current of the MAGT 100 is drained via the base B. Therefore, in the MAGT 100, the thyristor operation is interrupted as explained in the first embodiment.

Then, input of the control current signal S1 to the light emitting element D1 is interrupted to render the photo detector Q1 nonconductive. As a result, the pnp transistor Q4 is turned off and the gate potential of a p-channel MOS transistor Tr2 whose gate is connected to the collector of the transistor Q4 becomes negative to turn on the transistor Tr2. Therefore, a voltage nearly equal to a VEE level is applied to the gate G of the MAGT 100 to extinguish the channel. As a result, in the MAGT 100, the IGBT operation is interrupted as explained in the first embodiment.

Thus, the MAGT is turned off.

In Fig. 6, reference numerals R1 to R13 denote resistors.

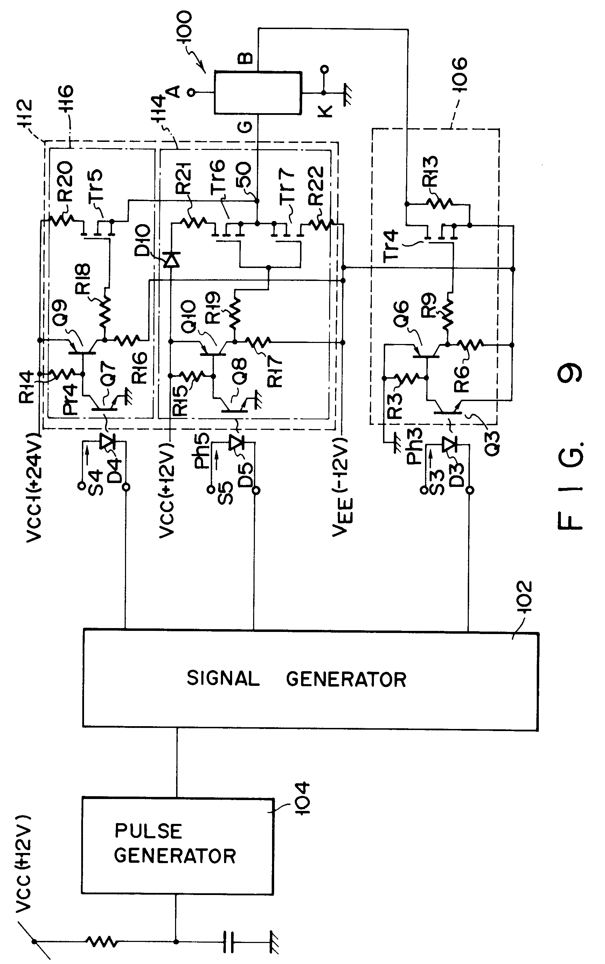

Further, the signal generator 102 is driven in response to a pulse generated from a signal generator 104 as a triggering pulse. Fig. 8 is a concrete circuit diagram of the signal generator 102. The operation thereof is effected in response to the control current signals S1 to S3 generated at timings shown in Fig. 7. The circuit includes five delay circuits 300 which are serially connected (in Fig. 8, the five delay circuits 300 are denoted by reference numerals 300A to 300E) and each of which includes an inverter 202 whose output terminal is connected to a set input terminal S of a flipflop (which is hereinafter referred to as an FF) 200 and a two-input AND gate 208 having a first input terminal connected to an output terminal Q of the FF 200 and a second input terminal connected to a reset terminal R of the FF 200 and connected to the output terminal Q of the FF 200 via an inverter 204 and a resistor 206.

The first delay circuit 300A is a circuit for setting the timing at which the control current signal S2 is generated and the output terminal of the AND gate 208 thereof is connected to an inverter 210A. The signal S2 is derived via the inverter 210A.

Further, the second and third delay circuits 300B and 300C are circuits for setting the timings at which the signal S1 is generated. The signal S1 is derived from an inverter 210B connected to the output terminal of the AND gate 208.

Likewise, the fourth and fifth delay circuits are circuits for setting the timings at which the signal S3 is generated. The signal S3 is derived from an inverter 210C connected to the output terminal of the AND gate 208.

The signal generating timings can be controlled by changing the capacitance of a capacitor 212 provided in the delay circuits 300A to 300E, for example. The signal generator 102 can be applied not only to the driving device described in the above embodiment but also to a driving device as will be described in the following embodiments.

[Fourth Embodiment]

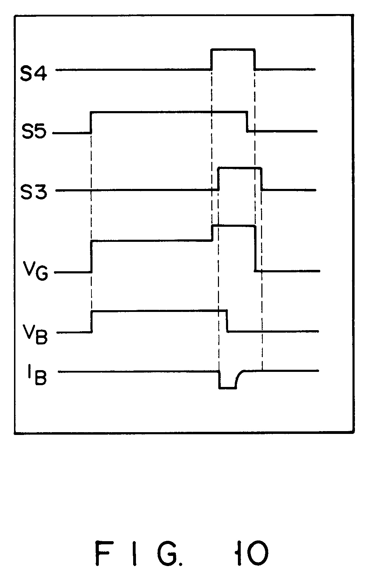

Fig. 9 is a diagram showing a second driving device for effecting the driving method according to this invention. Fig. 10 is a timing chart thereof. The driving device explained in this embodiment is used particularly for effecting the driving method explained with reference to the second embodiment.

As shown in Figs. 9 and 10, when an MAGT 100 is turned on, a control current signal S5 generated from a signal generator 102 is input to a light emitting element D5 of a photocoupler Ph5 and a photo detector Q8 of a turn-on potential supplying section 114 of a gate potential supplying section 112 is rendered conductive by the photocoupling effect. When the light receiving element Q8 is rendered conductive, a pnp transistor Q10 whose base is connected to the collector of the transistor Q8 is turned on, and an n-channel MOS transistor Tr6 whose gate is connected to the collector of the transistor Q10 is turned on. As a result, a potential nearly equal to a VCC level is applied to the gate G of the MAGT 100 so as to form a channel. Therefore, the MAGT 100 is turned on as explained in the second embodiment.

Further, when the MAGT 100 is turned off, a control current signal S4 generated from the signal generator 102 is input to a light emitting element D4 of a photocoupler Ph4, and a photo detector Q7 of a turn-off potential supplying section 116 of the gate potential supplying section 112 is rendered conductive by the photocoupling effect. When the light receiving element Q7 is rendered conductive, a pnp transistor Q9 whose base is connected to the collector of the transistor Q7 is turned on, and then an n-channel MOS transistor Tr5 whose gate is connected to the collector of the transistor Q9 is turned on. As a result, a potential nearly equal to a VCC1 level which is higher than the VCC level is applied to the gate G of the MAGT 100 so as to form a larger channel. Therefore, distribution of the on-current in the MAGT 100 is changed as explained in the second embodiment, and part of the on-current causing the IGBT operation becomes larger than part of the on-current causing the thyristor operation.

The path along which the voltage of the VCC1 level is transmitted and the path along which the voltage of the VCC level is transmitted are connected to each other at a node 50, and therefore there is a possibility that current flows from the VCC1 level to the VCC level. In order to solve this problem, in the example of this driving device, a diode D10 is connected between the drain of the MOS transistor Tr6 and VCC to prevent current from flowing from the VCC1 level to the VCC level.

Next, the control current signal S3 generated from the signal generator 102 is input to the light emitting element D3 of the photocoupler Ph3 so as to render the photo detector Q3 of the base potential supplying section 106 conductive by the photocoupling effect. When the photo detector Q3 is rendered conductive, a pnp transistor Q6 whose base is connected to the collector of the photo detector Q3 is turned on and an n-channel MOS transistor Tr4 whose gate is connected to the collector of the transistor Q6 is turned on. As a result, the on-current of the MAGT 100 is drained via the base B. Therefore, in the MAGT 100, the thyristor operation is interrupted as is explained in the second embodiment.

Then, input of the control current signals S4 and S5 to the light emitting elements D4 and D5 is interrupted to render the photo detectors Q7 and Q8 non-conductive. As a result, the pnp transistors Q9 and Q10 are turned off, thereby turning off the MOS transistors Tr5 and Tr6. Further, the gate potential of a p-channel MOS transistor Tr7 whose gate is connected to the collector of a transistor Q19 becomes negative so as to render the transistor Tr7 conductive. Therefore, a potential nearly equal to the VEE level is applied to the gate G of the MAGT 100, thereby extinguishing the channel. As a result, in the MAGT 100, the IGBT operation is interrupted as is described in the second embodiment.

As described above, the MAGT 100 is turned off.

In Fig. 9, reference numerals R3, R6, R9, R13, R14 to R22 denote resistors.

[Fifth Embodiment]

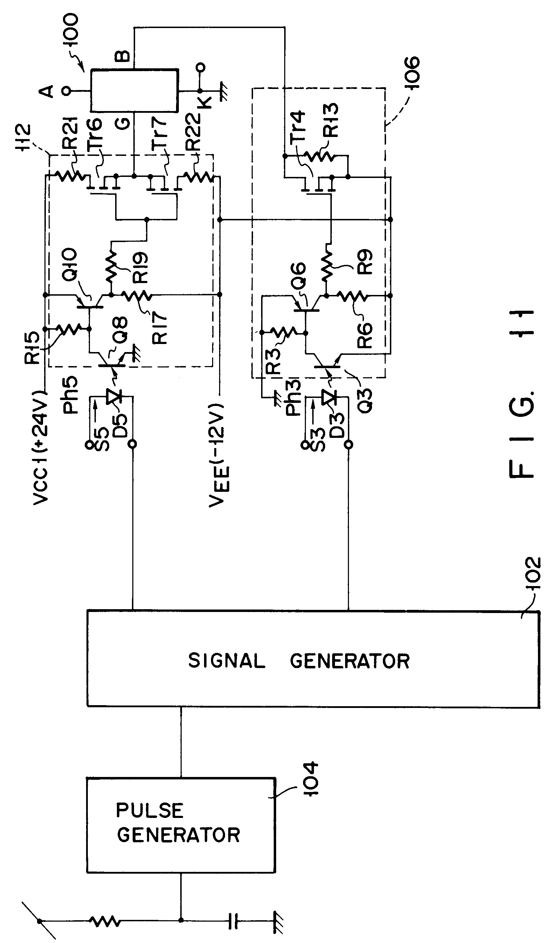

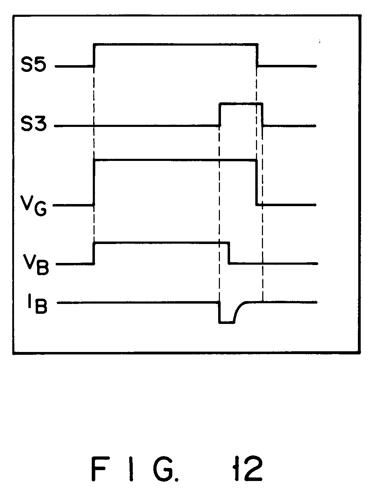

Fig. 11 is a diagram showing a third driving device for effecting the driving method according to this invention. Fig. 12 is a timing chart thereof.

In Fig. 11, portions which are the same as those of Fig. 9 are denoted by the same reference numerals.

As shown in Figs. 11 and 12, the control current signal S5 generated from the signal generator 102 is input to the light emitting element D5 of the photocoupler Ph5 in order to turn on the MAGT 100, and the photo detector Q8 of the gate potential supplying section 112 is rendered conductive by the photocoupling effect. As a result, the n-channel MOS transistor Tr6 is rendered conductive so that a voltage nearly equal to the VCC1 level can be applied to the gate G of the MAGT 100 to turn off the MAGT 100.

Further, when the MAGT 100 is turned off, the control current signal S3 generated from the signal generator 102 is input to the light emitting element D3 of the photocoupler Ph3 and the photo detector Q3 of the base potential supplying section 106 is rendered conductive by the photocoupling effect. As a result, the n-channel MOS transistor Tr4 is turned on so that the on-current of the MAGT 100 may be drained into the base B, thereby preventing the MAGT 100 from effecting the thyristor operation.

Next, input of the control current signal S5 to the light emitting element D5 is interrupted to render the photo detector Q8 nonconductive. As a result, the pnp transistor Q10 is turned off, the MOS transistor Tr6 is turned off and the MOS transistor Tr7 is turned on. Therefore, a potential nearly equal to the VEE level is applied to the gate G of the MAGT 100 and the IGBT operation of the MAGT 100 is interrupted.

As described above, the MAGT 100 is turned off.

It is also possible to initially set a potential applied to the gate G to a sufficiently high level such as the VCC1 level so as to increase the on-current passing through the channel in the on-state of the MAGT 100 and reduce the on-current flowing through the thyristor portion.

[Sixth Embodiment]

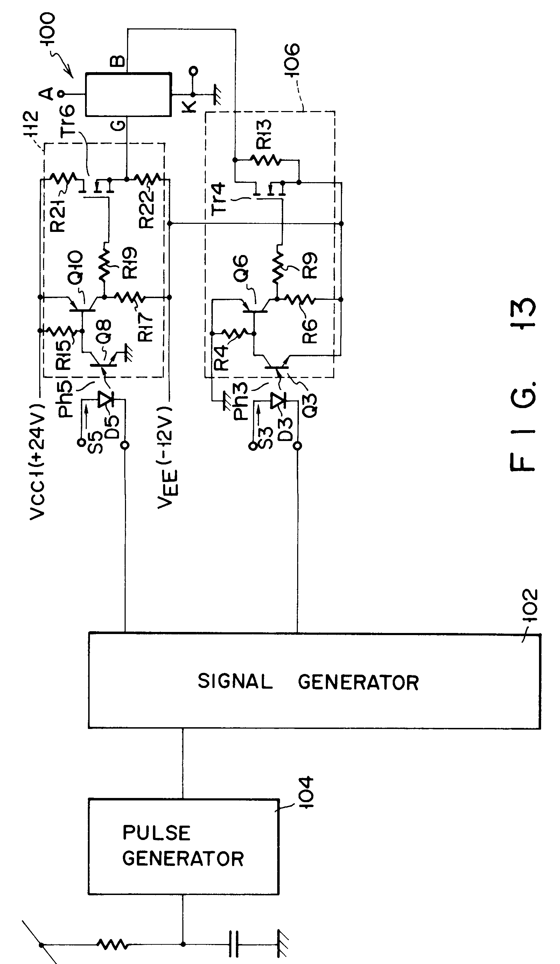

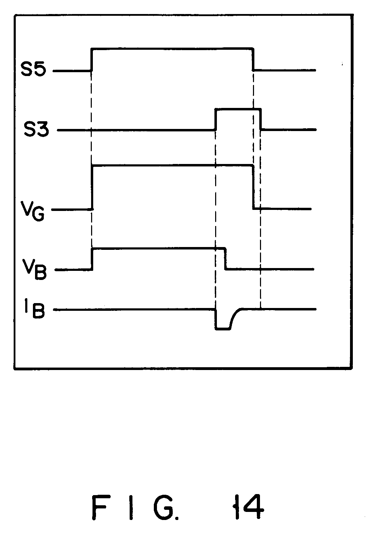

Fig. 13 is a diagram showing a fourth driving device for effecting the driving method according to this invention. Fig. 14 is a timing chart thereof.

In Fig. 13, portions which are the same as those of Fig. 9 are denoted by the same reference numerals.

As shown in Figs. 11 and 12, the control current signal S5 is input to the light emitting element D5 of the photocoupler Ph5 in order to turn on the MAGT 100, and the photo detector Q8 of the gate potential supplying section 112 is rendered conductive by the photocoupling effect. As a result, the n-channel MOS transistor Tr6 is turned on. At this time, a voltage obtained by dividing a potential difference between a potential of the VCC1 level and a potential of the VEE level by means of resistors R21 and R22 is applied to the gate G of the MAGT 100 to turn on the MAGT 100. Further, if the voltage obtained by voltage division is sufficiently high, the on-current flowing in the channel in the on-state of the MAGT 100 can be increased and the on-current flowing in the thyristor portion can be reduced.

Further, when the MAGT 100 is turned off, the control current signal S3 is input to the light emitting element D3 of the photocoupler Ph3 and the photo detector Q3 of the base potential supplying section 106 is rendered conductive by the photocoupling effect. As a result, the n-channel MOS transistor Tr4 is turned on so that the on-current of the MAGT 100 may be drained into the base B, thereby preventing the MAGT 100 from effecting the thyristor operation.

Next, if input of the control current signal S5 to the light emitting element D5 is interrupted to render the photo detector Q8 nonconductive, the transistor Tr6 is turned off. As a result, a potential nearly equal to the VEE level is applied to the gate G of the MAGT 100 and the IGBT operation of the MAGT 100 is interrupted.

As described above, the MAGT 100 is turned off.

This invention is not limited to the above embodiments, and can be variously modified without departing from the technical scope thereof. For example, in the four examples of the driving devices, the n-channel MOS transistor may be replaced by an npn transistor or the p-channel MOS transistor may be replaced by a pnp transistor.

Further, transmission of the control signal by use of the photocoupler may be effected by use of a combination of transistors.

Reference signs in the claims are intended for better understanding and shall not limit the scope.

## Claims

1. A method of driving a semiconductor device which includes a thyristor having a first semiconductor layer (18) of a first conductivity type, a second semiconductor layer (16) of a second conductivity type, a third semiconductor layer (14) of the first conductivity type and a fourth semiconductor layer (12) of the second conductivity type, a base electrode (30) connected to said second semiconductor layer (16), and an insulated gate FET having one of the source and drain connected to said third semiconductor layer (14), characterized in that

   when said semiconductor device is turned on and then said semiconductor device is turned off, the thyristor operation of said semiconductor device is interrupted and then the FET operation of said semiconductor device is interrupted.

2. A driving method according to claim 1, characterized in that the turn-on operation is effected by supplying a base current from said base electrode (30) into said second semiconductor layer (16) to turn on a bipolar transistor of a first conductivity type formed of said first, second and third semiconductor layers (14, 16, 18) and turn on a bipolar transistor of a second conductivity type formed of said second, third and fourth semiconductor layers (12, 14, 16) by a current flowing between the collector and emitter of said bipolar transistor of the first conductivity type, thereby turning on a thyristor formed of said first, second, third and fourth semiconductor layers (12, 14, 16, 18).

3. A driving method according to claim 1, characterized in that the turn-on operation is effected by supplying a base current from said base electrode (30) to said second semiconductor layer (16) to turn on a bipolar transistor of a first conductivity type formed of said first, second and third semiconductor layers (14, 16, 18) and turn on said insulated gate FET and supplying a base current to said third semiconductor layer (14) to turn on a bipolar transistor of a second conductivity type formed of said second, third and fourth semiconductor layers (12, 14, 16) so as to turn on a thyristor formed of said first, second, third and fourth semiconductor layers (12, 14, 16, 18).

4. A driving method according to claim 1, characterized in that the turn-off operation is effected by draining a base current of a bipolar transistor of a first conductivity type formed of said first, second and third semiconductor layers (14, 16, 18) via said base electrode (30) so as to turn off said bipolar transistor of the first conductivity type; and

   then turning off said insulated gate FET to interrupt supply of a base current to a bipolar transistor of a second conductivity type formed of said second, third and fourth semiconductor layers (12, 14, 16) so as to turn off said bipolar transistor of the second conductivity type.

5. A method of driving a semiconductor device which includes a first semiconductor layer (12) of a first conductivity type having a main surface,

   a second semiconductor layer (14) of a second conductivity type formed on said main surface of said first semiconductor layer (14),

   a third semiconductor layer (16) of the first conductivity type formed in the surface area of said second semiconductor layer (14),

   a fourth semiconductor layer (18) of the second conductivity type formed in the surface area of said third semiconductor layer (16),

   a gate insulation film (24) formed on said third semiconductor layer (16) between said second and fourth semiconductor layers (14 and 16),

   a gate electrode (26) formed on said gate insulation film (24),

   a first electrode (32) connected to said first semiconductor layer (12),

   a second electrode (30) connected to said third semiconductor layer (16), and

   a third electrode (28) connected to said fourth semiconductor layer (18);

   characterized in that when said semiconductor device is turned on and then said semiconductor device is turned off, a potential of said second electrode (30) is lowered to drain a current, which flows from said first electrode (32) into said third electrode (28) via said first, second, third and fourth semiconductor layers (12, 14, 16, 18), from said first electrode (32) into said second electrode (30) via said first, second and third semiconductor layers (12, 14, 16) so as to interrupt the thyristor operation; and

a potential of said gate electrode (26) is lowered to extinguish a channel formed in said third semiconductor layer (16) below said gate electrode (26) so as to interrupt the FET operation.

6. A driving method according to claim 5, characterized in that the operation of turning on said semiconductor device is effected by raising a potential of said second electrode (30) to turn on a thyristor formed of said first, second, third and fourth semiconductor layers (12, 14, 16, 18).

7. A driving method according to claim 6, characterized in that the operation of turning on said thyristor is effected by injecting a base current from said second electrode (30) into said third semiconductor layer (16) to turn on a bipolar transistor of a first conductivity type formed of said fourth, third and second semiconductor layers (14, 16, 18) and turn on a bipolar transistor of a second conductivity type formed of said first, second and third semiconductor layers (12, 14, 16) by a current flowing between the collector and emitter of said bipolar transistor of the first conductivity type.

8. A driving method according to claim 5, characterized in that the operation of turning on said semiconductor device is effected by raising potentials of said second electrode (30) and said gate electrode (26) to turn on a thyristor formed of said first, second, third and fourth semiconductor layers (12, 14, 16, 18) and turn on an insulated gate FET having said second fourth semiconductor layers (14, 18) respectively used as the source and drain thereof.

9. A driving method according to claim 8, characterized in that the operation of turning on said thyristor is effected by injecting a base current from said second electrode (30) into said third semiconductor layer (16) to turn on a bipolar transistor of a first conductivity type formed of said fourth, third and second semiconductor layers (14, 16, 18) and at the same time form a channel (22) in said third semiconductor layer (16) lying below said gate electrode (26), thereby permitting a base current to be injected into said second semiconductor layer (14) so as to turn on a bipolar transistor of a second conductivity type formed of said third, second and first semiconductor layers (12, 14, 16).

10. A driving method according to claim 6, characterized by further comprising:

a step of turning off said semiconductor device by raising a potential of said gate electrode (26) to form a channel (22) in said third semiconductor layer (16) lying below said gate electrode (26) before the thyristor operation is interrupted, thereby operating an insulated gate FET having said second and fourth semiconductor layers (14, 18) as the source and drain thereof.

11. A driving method according to claim 8, characterized by further comprising:

a step of turning off said semiconductor device by raising a potential of said gate electrode (26) to a level higher than that which has been set in the turn-on operation so as to set a current flowing in said insulated gate FET to be larger than that flowing in said thyristor.

12. A driving method according to claim 5, characterized in that the operation of turning off said semiconductor device is effected by draining a base current of a bipolar transistor of a first conductivity type formed of said fourth, third and second semiconductor layers (14, 16, 18) via said second electrode (30) so as to turn off said bipolar transistor of the first conductivity type; and then extinguishing a channel (22) which is formed in said third semiconductor layer (16) lying below said gate electrode (26) to interrupt supply of a base current to a bipolar transistor of a second conductivity type formed of said third, second and first semiconductor layers (12, 14, 16) so as to turn off said bipolar transistor of the second conductivity type.

13. A device for driving a semiconductor device (100) which includes a thyristor having a first semiconductor layer (18) of a first conductivity type, a second semiconductor layer (16) of a second conductivity type, a third semiconductor layer (14) of the first conductivity type and a fourth semiconductor layer (12) of the second conductivity type, a base electrode (30) connected to said second semiconductor layer (16), and an insulated gate FET having one of the source and drain connected to said third semiconductor layer (14) and having a gate electrode (26), characterized by comprising:

base potential supplying means (106) connected to said base electrode (30), for supplying a preset potential to said base electrode (30);

gate potential supplying means (112) connected to said gate electrode (26), for supplying a preset potential to said gate electrode (26); and

control signal supplying means (102) for supplying control signals to said base potential supplying means (106) and gate potential supplying means (112), said control signal supplying means (102) supplying a first control signal (S5) to said gate potential supplying means (112) and then supplying a second control signal (S3) to said base potential supplying means (106).

14. A driving device according to claim 13, characterized in that said base potential supplying means (106) includes turn-on base potential supplying means (108) for turning on said semiconductor device and turn-off base potential supplying means (110) for turning off said semiconductor device; and

said control signal supplying means (102) supplies a turn-on permission signal (S2) to said turn-on base potential supplying means (108), and then respectively supplies the first and second control signals (S1 and S3) to said gate potential supplying means (112) and said turn-off base potential supplying means (110) after supply of the turn-on permission signal (S2) is completed.

15. A driving device according to claim 13, characterized in that said gate potential supplying means (112) includes turn-on gate potential supplying means (114) for turning on said semiconductor device and turn-off gate potential supplying means (116) for turning off said semiconductor device; and

said control signal supplying means (102) sequentially supplies a turn-on permission signal (S5), the first control signal (S4) and the second control signal (S3) to said turn-on gate potential supplying means (114), said turn-off gate potential supplying means (116) and said base potential supplying means.

F I G. 1

F I G. 2

F I G. 3

F I G.  4

F I G.  5

F I G. 6

F I G.   7

F I G. 8

EP 0 463 325 A2

FIG. 9

EP 0 463 325 A2

F I G. 10

F I G. 11

F I G. 12

F I G. 13

EP 0 463 325 A2

F I G. 14